# FASCICULE DE BREVET EUROPEEN

(11) **EP 3 817 037 B1**
(45) Date de publication et mention de la délivrance du brevet: **18.05.2022**
(21) Numéro de dépôt: 20202709.0
(22) Date de dépôt: 20.10.2020
(51) Int. Cl.: H01L 21/762

(54) **PROCÉDÉ DE TRANSFERT D'UNE COUCHE MINCE À L'AIDE D'UN POLYMÈRE PRÉCÉRAMIQUE CHARGÉ**
VERFAHREN ZUM TRANSFER EINER DÜNNSCHICHT MITHILFE EINES PRÄKERAMISCHEN GELADENEN POLYMERS
METHOD FOR TRANSFERRING A THIN LAYER WITH THE HELP OF A LOADED PRE-CERAMIC POLYMER

(30) Priorité: 28.10.2019 FR 1912056
(43) Date de publication de la demande: 05.05.2021
(73) Titulaire: Commissariat à l'énergie atomique et aux énergies alternatives, 75015 Paris (FR)
(72) Inventeur: BENAISSA, Lamine, 38054 GRENOBLE CEDEX 09 (FR); ROUMANIE, Marilyne, 38054 GRENOBLE CEDEX 09 (FR)
(74) Mandataire: Brevalex

(56) Documents cités:
- US-A1- 2013 092 320
- US-A1- 2017 309 517

## Description

### DOMAINE TECHNIQUE

Le domaine de l'invention est celui des procédés de transfert d'une couche semi-conductrice d'un substrat donneur vers un substrat support qui mettent en œuvre une fracture le long d'un plan de fragilisation formé par implantation d'espèces dans le substrat donneur. De tels procédés permettent la réalisation de substrats avancés pour la microélectronique, la photonique ou l'électronique de puissance, notamment la réalisation de substrats SeOI (pour « Semiconductor On Insulator ») comprenant une couche semi-conductrice séparée du substrat support par une couche isolante enterrée.

### TECHNIQUE ANTÉRIEURE

La technologie Smart Cut^{™} est une technique bien connue pour permettre le transfert de couches minces de matériaux semi-conducteurs. Selon cette technique, des espèces ioniques telles que de l'hydrogène et/ou de l'hélium sont implantées dans un substrat donneur afin d'y former un plan de fragilisation. Le substrat donneur est par la suite mis en contact avec un substrat support, par exemple par collage direct. Cette technique fait ensuite appel au développement des défauts générés au niveau du plan de fragilisation. Ce développement implique un apport énergétique, généralement réalisé au moyen d'un traitement thermique de quelques centaines de degrés, 500°C typiquement, pendant quelques dizaines de minutes. Cela conduit à la formation d'une couche confinée de cavités et de microfissures au sein de laquelle va s'initier et se propager une fracture. Cette fracture sépare le substrat donneur le long du plan de fragilisation et une couche mince du substrat donneur est ainsi transférée sur le substrat support.

La technologie Smart Cut^{™} exploite des procédés standards de l'industrie microélectronique et est donc intrinsèquement limitée par les capacités de ces procédés.

Il en est ainsi de l'épaisseur atteignable pour les couches qui, comme la couche isolante enterrée, sont déposées selon les procédés de dépôt conventionnels tels que le dépôt physique par phase vapeur (PVD pour « Physical Vapor Deposition »), le dépôt chimique par phase vapeur (CVD pour « Chemical Vapor Déposition), le dépôt par évaporation ou le dépôt par épitaxie. Or une couche isolante enterrée suffisamment épaisse permettrait dans des applications radio-fréquence, par exemple pour les réseaux 5G, de s'affranchir d'un coûteux substrat support de haute résistivité et d'éventuelles couches de piégeage dites « Trap Rich » et donc d'obtenir un gain en termes de performance et de coût. Une couche isolante enterrée suffisamment épaisse permettrait également une meilleure tenue en tension de composants de puissance.

L'assemblage du substrat donneur implanté et du substrat support au moyen d'un collage direct présente quant à lui l'inconvénient de nécessiter une grande planéité et une faible rugosité des deux surfaces à coller. Il doit ainsi s'accompagner de procédés de préparation de surface nécessairement coûteux.

Des contraintes portent par ailleurs sur la couche isolante enterrée qui doit présenter à la fois un coefficient de dilatation thermique proche de celui de la couche mince transférée et une bonne tenue en température pour permettre la mise en œuvre du procédé de transfert et un recuit haute température (de 400°C à 1000°C suivant les matériaux) de guérison des défauts générés par l'implantation dans la couche mince transférée. Ces contraintes excluent ainsi d'avoir recours à des polymères traditionnels, comme le DVS-bis-BCB, les polyimides et les polymères photosensibles mentionnés dans le brevet EP 2 608 252 B1.

US 2017/309517 A1 révèle une méthode de formation d'une plaquette SOI utilisant un précurseur polymère formant une céramique comme couche d'adhérence.

US 2013/092320 A1 révèle une méthode de transfert d'une fine couche de silicium monocristallin à partir du substrat donneur sans formation de défauts, améliorant ainsi le coefficient de dilatation thermique, la planéité et la rugosité de surface de la fine couche de silicium monocristallin.

### EXPOSÉ DE L'INVENTION

L'invention a pour objectif de s'affranchir des inconvénients susmentionnés des procédés standards de l'industrie microélectronique tout en respectant les contraintes d'ordre thermique pesant sur la couche isolante enterrée. Elle propose pour ce faire un procédé de transfert d'un substrat donneur vers un substrat support d'une couche mince présentant un premier coefficient de dilatation thermique, comprenant les étapes :
- de formation d'un plan de fragilisation dans le substrat donneur ;
- de formation d'une couche électriquement isolante en surface du substrat donneur et/ou du substrat support ;
- de réalisation d'un assemblage par mise en contact du substrat donneur et du substrat support par l'intermédiaire de la couche électriquement isolante ; et
- de séparation de l'assemblage par fracture le long du plan de fragilisation.

La formation de la couche isolante comprend un revêtement du substrat donneur et/ou du substrat support par une formulation d'enduction comportant un matériau composite constitué d'une matrice en un polymère précéramique chargée de particules. Le matériau composite présente un deuxième coefficient de dilatation thermique, le deuxième coefficient de dilatation thermique différant du premier coefficient de dilatation thermique d'au plus de 20 % du premier coefficient de dilatation thermique.

Certains aspects préférés mais non limitatifs de ce procédé sont les suivants :
le revêtement est réalisé de manière à ce que la couche électriquement isolante présente une épaisseur supérieure à 20 µm ;
le revêtement est réalisé de manière à ce que la couche électriquement isolante présente une épaisseur inférieure à 300 µm ;
la réalisation de l'assemblage comprend une thermo-compression du substrat donneur et du substrat support ;
la thermo-compression est réalisée à une pression comprise entre 10 kN et 30 kN ;
la thermo-compression est réalisée à une température supérieure à 100°C ;
la séparation comprend un recuit réalisé à une température supérieure à la température de la thermo-compression ;
ledit revêtement est réalisé sur une couche diélectrique préalablement déposée sur le substrat donneur ;
ladite formulation d'enduction présente un taux de charges supérieur à 50 % en volume ;
le substrat support est en un matériau polycristallin.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés qui représentent différentes étapes consécutives du procédé selon l'invention et sur lesquels :
La figure 1 illustre la formation du plan de fragilisation ;
La figure 2 illustre le dépôt d'une couche diélectrique ;
La figure 3 illustre le revêtement par la couche électriquement isolante en un matériau composite ;
La figure 4 illustre l'assemblage du substrat donneur et du substrat support ;
La figure 5 illustre la séparation de l'assemblage au niveau du plan de fragilisation ;
La figure 6 illustre le substrat SeOI obtenu par la mise en œuvre du procédé selon l'invention.

### DESCRIPTION DÉTAILLÉE

L'invention porte sur un procédé de transfert d'un substrat donneur vers un substrat support d'une couche mince présentant un premier coefficient de dilatation thermique. La couche mince est par exemple une couche de silicium, de germanium, de carbure de silicium ou d'un matériau III-V. Le substrat support peut être dans un matériau monocristallin. Alternativement, le substrat support peut être un substrat bas coût en un matériau polycristallin, comme du silicium polycristallin ou du carbure de silicium polycristallin.

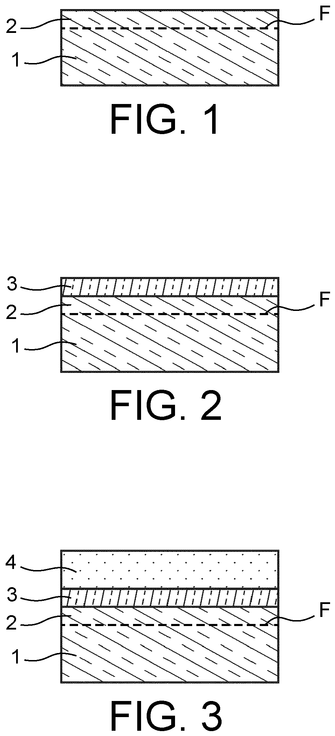

En référence à la figure 1, ce procédé comprend une étape de formation d'un plan de fragilisation F dans l'épaisseur du substrat donneur 1 au moyen d'une implantation d'espèces ioniques, par exemple de l'hydrogène et/ou de l'hélium. Ce plan de fragilisation délimite une portion superficielle du substrat donneur qui va former la couche mince à transférer 2 d'une partie massive du substrat donneur. L'épaisseur de cette portion superficielle est par exemple comprise entre 10nm et 3µm.

En référence à la figure 2, ce procédé peut comprendre le dépôt d'une couche diélectrique 3 en surface de l'un et/ou l'autre du substrat donneur et du substrat support. Cette couche diélectrique 3 participe à l'effet raidisseur lors de la séparation au niveau du plan de fragilisation.

Cette couche diélectrique 3 est déposée selon un procédé de dépôt conventionnel, à une température inférieure à une température (typiquement une température supérieure à 300°C) qui risquerait, lorsque déposée sur le substrat donneur implanté, de provoquer un bullage, c'est à dire une maturation de microcavités dans le plan de fragilisation F qui, en l'absence d'un raidisseur rapporté sur le substrat donneur, conduirait à une déformation de sa surface susceptible de contrarier un assemblage avec le substrat receveur.

En référence à la figure 3, le procédé comprend une étape de formation d'une couche électriquement isolante 4 en surface du substrat donneur et/ou du substrat support. Conformément à l'invention, la formation de cette couche isolante 4 comprend un revêtement du substrat donneur et/ou du substrat support par une formulation d'enduction. Cette formulation d'enduction comprend, le cas échéant consiste en, un matériau composite constitué d'une matrice en un polymère précéramique chargée de particules.

Dans un mode de réalisation possible représenté sur les figures 1 et 2, la couche diélectrique 3 et la couche électriquement isolante 4 sont successivement formées sur le substrat donneur. Dans un mode de réalisation alternatif, la couche électriquement isolante 4 et la couche diélectrique 3 sont successivement formées sur le substrat support. Dans encore un mode de réalisation, la couche diélectrique 3 est formée sur le substrat donneur et la couche électriquement isolante 4 est formée sur le substrat support.

Le polymère précéramique est par exemple un polymère à base de silicium, comme un polysiloxane, un polysilsesquioxane, un polycarbosiloxane, un polycarbosilane, un polysilylcarbodiimide, un polysilsesquicarbodiimide, un polysilsesquiazane, un polysilazane, un polyborosilazane, un polyborosilane ou un polyborosiloxane. Le choix du polymère précéramique peut être réalisé en fonction du matériau de la couche mince transférée, en venant par exemple choisir une base carbosilane pour une couche mince de carbure de silicium ou encore une base de siloxane ou de silazane pour une couche mince de silicium ou de silicium oxydé ou de nitrure de silicium.

Un polymère précéramique est un polymère organique/inorganique qui est généralement utilisé afin de réaliser après traitement thermique à haute température des objets céramiques dits PDC (pour « Polymer-Derived Ceramics). Un tel polymère précéramique peut être appliqué sous forme de revêtement. Il se présente sous forme liquide ou est soluble dans des solvants organiques et peut être déposé sur un substrat par voie liquide ou en phase vapeur. Il est possible d'utiliser toutes les techniques de mise en forme de polymères telles que l'enduction centrifuge (*spin coating*), l'enduction par trempage (*dip coating*), la pulvérisation, la sérigraphie ou le coulage en bande.

Dans le cadre de l'invention, le revêtement est de préférence réalisé de manière à ce que la couche électriquement isolante 4 soit une couche épaisse présentant une épaisseur supérieure à 20 µm. Ce revêtement peut en outre être réalisé de manière à ce que la couche électriquement isolante 4 présente une épaisseur inférieure à 300 µm.

Selon l'invention, le matériau composite formant la couche électriquement isolante et constitué d'une matrice en un polymère précéramique chargée de particules présente un deuxième coefficient de dilatation thermique. Ce deuxième coefficient de dilatation thermique diffère du premier coefficient de dilatation thermique, i.e. celui de la couche mince, d'au plus de 20 % du premier coefficient de dilatation thermique.

Les particules sont typiquement réalisées dans des matériaux électriquement isolants ou semi-conducteurs. Outre leurs propriétés thermomécaniques, ces particules peuvent présenter d'autres propriétés physiques intéressantes, comme par exemple des propriétés thermiques, ferroélectriques, magnétiques ou optiques.

Ces particules, sont de préférence mélangées avec la matrice de telle manière que la formulation d'enduction présente un taux de charges supérieur à 50% en volume. Il est possible, par exemple améliorer des propriétés thermiques, d'utiliser des formulations contenant plusieurs tailles et formes de particules pour favoriser les chemins de percolation.

La couche électriquement isolante 4, thermiquement conductrice, présente une excellente tenue en température (elle tient par exemple sous forme de colle à des températures supérieures à 350°C) et un coefficient de dilatation thermique suffisamment proche de celui de la couche mince pour permettre à la couche mince transférée de subir des traitements thermique haute température, comme une guérison des défauts générés par l'implantation.

Ainsi, la couche électriquement isolante 4 est réalisé en un matériau compatible en terme de CTE avec la couche mince (cette propriété étant également fonction de l'épaisseur de dépôt) et modulable en termes de propriétés électriques et thermiques en fonction de la charge ajoutée. D'autre part, ce matériau participe à l'effet raidisseur avec la couche de diélectrique lors de la séparation au niveau du plan de fragilisation. Il permet également de travailler jusqu'à la température de guérison des substrats, voire au-delà suivant la formulation développée matrice+charges. Il permet aussi de travailler avec des couches épaisses, typiquement de plus de 10 µm, déposées en un passage par exemple avec l'enduction (dépôt de quelques secondes).

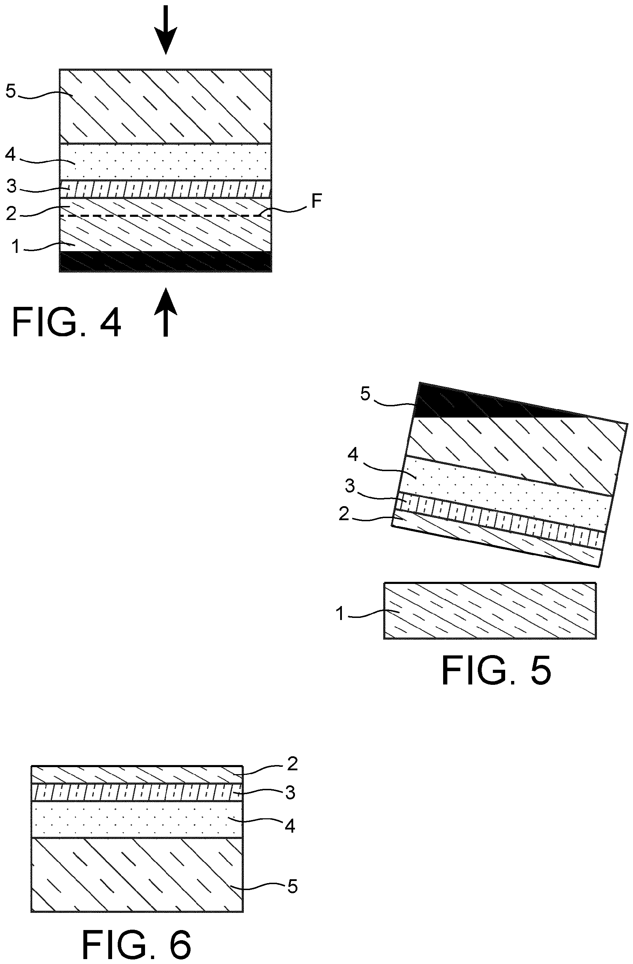

En référence à la figure 4, le procédé comprend une étape d'assemblage du substrat donneur 1 et du substrat support 5 par l'intermédiaire de la couche isolante 4. La matrice en un polymère précéramique forme une matrice adhésive qui permet de relâcher les contraintes portant l'état de surface du substrat support 5 et donc d'alléger, voire de passer outre, les procédés de préparation de surface du substrat support 5.

L'assemblage peut être réalisé par thermo-compression, par exemple en maintenant les substrats 1, 5 sous une pression comprise entre 10kN et 30kN. Il s'effectue à une température supérieure à la température de réticulation de la matrice de polymère précéramique, typiquement à une température supérieure à 100 °C. Cette température ne dépasse pas une température (typiquement une température supérieure à 300°C) qui risquerait de provoquer un bullage.

En référence à la figure 5, le procédé comprend une étape de séparation de l'assemblage par fracture le long du plan de fragilisation. Cette séparation est obtenue au moyen d'un apport énergétique, généralement réalisé au moyen d'un traitement thermique.

Cette séparation conduit au transfert de la couche mince 2 du substrat donneur 1 au substrat support et à l'obtention de la structure SeOI de la figure 6. Comme discuté précédemment, cette structure, qui peut être obtenue en un nombre minimal d'étapes, peut présenter :
- une couche mince 2 en un matériau semi-conducteur entre 10nm et 3µm ;
- une couche électriquement isolante 4 de forte épaisseur de 20 à 300 µm et capable d'accommoder le coefficient de dilatation thermique de la couche mince ;
- un substrat support 5 qui peut présenter une qualité cristalline inférieure à celle de la couche mince.

Un exemple de réalisation d'une telle structure (couche mince 2 de 1,2 µm d'épaisseur sur une couche isolante 4 d'environ 250 µm d'épaisseur) est le suivant. Il débute par la fourniture d'un substrat donneur de silicium de 200 mm de diamètre et de 725 µm d'épaisseur. Après nettoyage RCA, ce substrat est soumis à une implantation d'ions hydrogène d'énergie 160 keV et de dose 6.10¹⁶/cm² pour y former le plan de fragilisation. Une couche de 4 µm d'oxyde TEOS est déposée sur le substrat donneur à une température de 200°C. Une formulation d'enduction est étalée sur la couche de TEOS pour former une couche isolante de 250 µm d'épaisseur. Cette formulation est obtenue en venant dissoudre dans un solvant référencé sous la marque Diestone^{®} DLS (Socomore) du po(méthyl)silsesquioxane (Silres^{®}MK, Wacker Chemie AG) de formule (CH₃SiO_{1.5})ₙ et des particules de Si₃N₄ de 1,6 µm de diamètre représentant 80% en volume de la formulation. Après étalement, la formulation d'enduction est soumise à un séchage à température ambiante pendant 12 heures. Le procédé se poursuit avec l'assemblage par thermo-compression avec un substrat support de silicium de 725 µm d'épaisseur pendant deux heures, sous une pression de 30 kN et une température de 200°C. La séparation au niveau du plan de fragilisation est obtenue au moyen d'un recuit thermique comprenant une première rampe de 10°C/min jusqu'à atteindre un premier palier à 300°C, lequel est maintenu pendant une heure, puis une seconde rampe de 10°C/min jusqu'à atteindre un second palier à 500°C, lequel est maintenu pendant une heure.

## Revendications

1. Procédé de transfert d'un substrat donneur (1) vers un substrat support (5) d'une couche mince (2) présentant un premier coefficient de dilatation thermique, comprenant les étapes :
- de formation d'un plan de fragilisation (F) dans le substrat donneur (1) ;
- de formation d'une couche électriquement isolante (4) en surface du substrat donneur et/ou du substrat support ;
- de réalisation d'un assemblage par mise en contact du substrat donneur (1) et du substrat support (5) par l'intermédiaire de la couche électriquement isolante (4) ;
- de séparation de l'assemblage par fracture le long du plan de fragilisation ;
**caractérisé en ce que** la formation de la couche isolante comprend un revêtement du substrat donneur et/ou du substrat support par une formulation d'enduction comportant un matériau composite constitué d'une matrice en un polymère précéramique chargée de particules, le matériau composite présentant un deuxième coefficient de dilatation thermique, le deuxième coefficient de dilatation thermique différant du premier coefficient de dilatation thermique d'au plus de 20 % du premier coefficient de dilatation thermique.

2. Procédé selon la revendication 1, dans lequel le revêtement est réalisé de manière à ce que la couche électriquement isolante (4) présente une épaisseur supérieure à 20 µm.

3. Procédé selon la revendication 2, dans lequel le revêtement est réalisé de manière à ce que la couche électriquement isolante (4) présente une épaisseur inférieure à 300 µm.

4. Procédé selon l'une des revendications 1 à 3, dans lequel la réalisation de l'assemblage comprend une thermo-compression du substrat donneur et du substrat support.

5. Procédé selon la revendication 4, dans lequel la thermo-compression est réalisée à une pression comprise entre 10 kN et 30 kN.

6. Procédé selon l'une des revendications 4 et 5, dans lequel la thermo-compression est réalisée à une température supérieure à 100°C.

7. Procédé selon la revendication 6, dans lequel la séparation comprend un recuit réalisé à une température supérieure à la température de la thermo-compression.

8. Procédé selon l'une des revendications 1 à 7, dans lequel ledit revêtement est réalisé sur une couche diélectrique préalablement déposée sur le substrat donneur.

9. Procédé selon l'une des revendications 1 à 8, dans lequel ladite formulation d'enduction présente un taux de charges supérieur à 50 % en volume.

10. Procédé selon l'une des revendications 1 à 9, dans lequel le substrat support est en un matériau polycristallin.

## Patentansprüche

1. Verfahren zum Übertragen eines Donatorsubstrats (1) auf ein Trägersubstrat (5) einer Dünnschicht (2), die einen ersten Wärmeausdehnungskoeffizienten aufweist, umfassend die Schritte:
- Bildung einer Versprödungsebene (F) im Donatorsubstrat (1);
- Bildung einer elektrisch isolierenden Schicht (4) auf der Oberfläche des Donatorsubstrats und/oder des Trägersubstrats;
- Realisierung einer Verbindung durch Kontaktierung des Donatorsubstrats (1) mit dem Trägersubstrat (5), mit Hilfe der elektrisch isolierenden Schicht (4);
- Trennung der Verbindung durch Bruch entlang der Versprödungsebene;
**dadurch gekennzeichnet, dass** die Bildung der isolierenden Schicht eine Beschichtung des Donatorsubstrats und/oder des Trägersubstrats durch eine Lackformulierung umfasst, die einen Verbundwerkstoff aus einer Matrize aus einem mit Partikeln beladenen präkeramischen Polymer enthält, wobei der Verbundwerkstoff einen zweiten Wärmeausdehnungskoeffizienten aufweist, wobei der zweite Wärmeausdehnungskoeffizient vom ersten Wärmeausdehnungskoeffizienten um höchstens 20% des ersten Wärmeausdehnungskoeffizienten abweicht.

2. Verfahren nach Anspruch 1, wobei die Beschichtung so realisiert wird, dass die elektrisch isolierende Schicht (4) eine Dicke von mehr als 20 µm aufweist.

3. Verfahren nach Anspruch 2, wobei die Beschichtung so realisiert wird, dass die elektrisch isolierende Schicht (4) eine Dicke von weniger als 300 µm aufweist.

4. Verfahren nach einem der Ansprüche 1 bis 3, wobei die Realisierung der Verbindung eine Thermokompression des Donatorsubstrats und des Trägersubstrats umfasst.

5. Verfahren nach Anspruch 4, wobei die Thermokompression mit einem Druck zwischen 10 kN und 30 kN realisiert wird.

6. Verfahren nach einem der Ansprüche 4 und 5, wobei die Thermokompression bei einer Temperatur über 100 °C realisiert wird.

7. Verfahren nach Anspruch 6, wobei die Trennung ein Glühen umfasst, das bei einer Temperatur realisiert wird, die höher ist als die Temperatur der Thermokompression.

8. Verfahren nach einem der Ansprüche 1 bis 7, wobei die Beschichtung auf einer zuvor auf dem Donatorsubstrat aufgebrachten dielektrischen Schicht realisiert wird.

9. Verfahren nach einem der Ansprüche 1 bis 8, wobei die Lackformulierung einen Füllstoffgehalt von mehr als 50 Vol.-% aufweist.

10. Verfahren nach einem der Ansprüche 1 bis 9, wobei das Trägersubstrat aus einem polykristallinen Material besteht.

## Claims

1. A method for transferring, from a donor substrate (1) to a carrier substrate (5), a thin layer (2) having a first coefficient of thermal expansion, comprising the steps of:
- forming an embrittlement plane (F) in the donor substrate (1);
- forming an electrically insulating layer (4) on the surface of the donor substrate and/or of the carrier substrate;
- producing an assembly by placing the donor substrate (1) and the carrier substrate (5) in contact with one another via the electrically insulating layer (4);
- separating the assembly by fracturing along the embrittlement plane;
wherein forming the insulating layer comprises coating the donor substrate and/or the carrier substrate with a coating formulation including a composite material formed by a matrix made of a particle-filled preceramic polymer, the composite material having a second coefficient of thermal expansion, the second coefficient of thermal expansion differing from the first coefficient of thermal expansion by no more than 20 % of the first coefficient of thermal expansion.

2. The method according to claim 1, wherein the coating is produced such that the electrically insulating layer (4) has a thickness of greater than 20 µm.

3. The method according to claim 2, wherein the coating is produced such that the electrically insulating layer (4) has a thickness of less than 300 µm.

4. The method according to any of claims 1 to 3, wherein producing the assembly comprises thermocompression of the donor substrate and of the carrier substrate.

5. The method according to claim 4, wherein thermocompression is carried out at a pressure that lies in the range of 10 kN to 30 kN.

6. The method according to any of claims 4 and 5, wherein thermocompression is carried out at a temperature greater than 100°C.

7. The method according to claim 6, wherein separation comprises an annealing carried out at a temperature that is greater than the temperature at which the thermocompression is carried.

8. The method according to any of claims 1 to 7, wherein said coating is produced on a dielectric layer previously deposited on the donor substrate.

9. The method according to any of claims 1 to 8, wherein said coating formulation has a filling factor of greater than 50 % in volume.

10. The method according to any of claims 1 to 9, wherein the carrier substrate is made of a polycrystalline material.
